# DEMANDE DE BREVET EUROPEEN

(11) **EP 4 474 532 A1**
(43) Date de publication de la demande: **11.12.2024**
(21) Numéro de dépôt: 24178613.6
(22) Date de dépôt: 28.05.2024
(51) Int. Cl.: C30B 23/04, C23C 16/00, C30B 25/04, C30B 29/40

(54) **PROCÉDÉ DE FABRICATION D'UN CRISTAL SUR UN SUBSTRAT CRISTALLIN**

(30) Priorité: 09.06.2023 FR 2305845
(71) Demandeur: Commissariat à l'Energie Atomique et aux Energies Alternatives, 75015 Paris (FR)
(72) Inventeur: GUEDJ, Cyril, 38054 Grenoble cedex 09 (FR)
(74) Mandataire: INNOV-GROUP

(57) **Abrégé**

Procédé de fabrication d'un cristal (1) sur un substrat (2) cristallin, comportant les étapes :
a) modéliser une interface (I) entre un réseau cristallin du cristal (1) et un réseau cristallin du substrat (2) cristallin ;
b) déterminer une distribution spatiale d'une énergie potentielle élastique à l'interface (I) modélisée lors de l'étape a) ;
c) identifier des minima (Eₘᵢₙ) de l'énergie potentielle élastique à partir de la distribution spatiale déterminée lors de l'étape b) ;
d) former une couche interfaciale, nanostructurée, sur le substrat (2) cristallin ; la couche interfaciale comportant des nanotunnels traversants, agencés selon une répartition correspondant aux minima (Eₘᵢₙ) de l'énergie potentielle élastique identifiés lors de l'étape c) ; la couche interfaciale étant formée d'une matière différente du cristal (1) et du substrat (2) cristallin ;
e) former le cristal (1) sur la couche interfaciale, via les nanotunnels traversants délimitant des sites de nucléation (20) du substrat (2) cristallin.

## Description

### Domaine technique

L'invention se rapporte au domaine technique de la fabrication d'un cristal sur un substrat cristallin.

L'invention trouve notamment son application dans l'épitaxie d'un supercristal sur une surface d'un substrat cristallin, le supercristal et le substrat cristallin présentant un désaccord de maille.

### État de l'art

Un procédé connu de l'état de la technique consiste en une épitaxie conventionnelle d'un cristal sur un substrat cristallin. Lorsque le cristal et le substrat cristallin présentent un désaccord de maille, une telle épitaxie conventionnelle est généralement défectueuse au-delà d'une épaisseur critique du cristal. En effet, l'énergie potentielle élastique issue des déformations est susceptible d'engendrer des défauts tels que des dislocations.

Des solutions ont été envisagées, telles que la croissance d'une couche tampon (« *buffer*» en langue anglaise) intercalée entre la substrat cristallin et le cristal à épitaxier. Toutefois, une telle solution n'est pas entièrement satisfaisante car elle engendre toujours la présence de défauts, ainsi que des fluctuations de déformations résiduelles, et nécessite un temps d'opération important avec des étapes technologiques nombreuses.

Des procédés de nano-hétéroépitaxie du cristal et de nanostructuration (« *nanopatteming*» en langue anglaise) du substrat cristallin sont également connus, mais conduisent également à des défauts résiduels.

L'homme du métier recherche donc une solution de fabrication d'un cristal sur un substrat cristallin permettant de réduire drastiquement la formation de défauts au sein du cristal, en particulier en cas de fort désaccord de maille (>10 %) entre le cristal et le substrat cristallin.

### Exposé de l'invention

L'invention vise à remédier en tout ou partie aux inconvénients précités. A cet effet, l'invention a pour objet un procédé de fabrication d'un cristal sur un substrat cristallin, comportant les étapes :
a) modéliser une interface entre un réseau cristallin du cristal et un réseau cristallin du substrat cristallin ;
b) déterminer une distribution spatiale d'une énergie potentielle élastique à l'interface modélisée lors de l'étape a) ;
c) identifier des minima de l'énergie potentielle élastique à partir de la distribution spatiale déterminée lors de l'étape b) ;
d) former une couche interfaciale, nanostructurée, sur le substrat cristallin ; la couche interfaciale comportant des nanotunnels traversants, agencés selon une répartition correspondant aux minima de l'énergie potentielle élastique identifiés lors de l'étape c) ; la couche interfaciale étant formée d'une matière différente du cristal et du substrat cristallin ;
e) former le cristal sur la couche interfaciale, via les nanotunnels traversants délimitant des sites de nucléation du substrat cristallin.

Ainsi, un tel procédé selon l'invention permet d'envisager une épitaxie d'un cristal (notamment un supercristal) sur une grande surface du substrat cristallin, grâce à une identification préalable des minima d'énergie potentielle élastique résultant des étapes a), b) et c). La couche interfaciale nanostructurée, formée lors de l'étape d), permet d'exposer uniquement des zones du substrat cristallin favorables à la croissance épitaxiale, grâce à la répartition des nanotunnels traversants. En effet, ces zones du substrat cristallin mises à nu à l'issue de l'étape d) présentent des minima d'énergie potentielle élastique, minimisant donc la défectivité interfaciale, et constituant ainsi des sites de nucléation privilégiés. Les zones du substrat cristallin défavorables à la croissance épitaxiale (i.e. avec une énergie potentielle élastique élevée, supérieure au seuil d'énergie de formation de défauts cristallins) sont des réservoirs de défauts cristallins masqués par la couche interfaciale et ne sont donc pas accessibles comme sites de nucléation lors de l'étape e).

La couche interfaciale est formée d'une matière différente du cristal et différente du substrat cristallin afin d'éviter une future concurrence des matériaux, par exemple lors de la formation du cristal par épitaxie lors de l'étape e).

Le procédé selon l'invention peut comporter une ou plusieurs des caractéristiques suivantes.

Selon une caractéristique de l'invention, la couche interfaciale formée lors de l'étape d) est une monocouche formant un matériau bidimensionnel.

Ainsi, un avantage procuré est de pouvoir délimiter spatialement la répartition des nanotunnels traversants avec une grande précision. Un autre avantage réside dans la grande aptitude de la majorité des matériaux bidimensionnels à s'accommoder de cisaillements plus élevés que les matériaux tridimensionnels. Cette souplesse (« *compliance*» en langue anglaise) translationnelle locale importante permet d'obtenir une distribution très large des angles de liaisons atomiques interfaciales, au lieu de former des défauts plus étendus tels que des dislocations classiquement observées pour les matériaux tridimensionnels.

Selon une caractéristique de l'invention, la matière de la couche interfaciale formée lors de l'étape d) est en phase solide ou en phase gazeuse.

Selon une caractéristique de l'invention, la matière en phase solide de la couche interfaciale formée lors de l'étape d) est choisie parmi :
- un dichalcogénure d'un métal de transition, de préférence le disulfure de molybdène MoS₂, le disulfure d'étain SnS₂, le disulfure de tungstène WS₂, le disulfure de vanadium VS₂, le disulfure de titane TiS₂ ;
- le graphène ou un dérivé du graphène, le dérivé du graphène étant de préférence un carbone amorphe notamment hydrogéné, un carbone de type diamant, une structure haeckelite ;
- un nitrure de bore BN, notamment hydrogéné, de préférence hexagonal ;
- un matériau de formule brute SiOₓC_{y}H_{z} ;
- un copolymère à blocs, de préférence auto-organisé ;
- un carbure d'un métal de transition, de préférence de type MXene ;
- un réseau métallo-organique,
- le borophène, le silicène, le germanène, le stanène, le phosphorène.

Selon une caractéristique de l'invention, la matière en phase gazeuse de la couche interfaciale formée lors de l'étape d) est choisie parmi le dihydrogène H₂, le diazote N₂, le dioxygène O₂, l'argon Ar, l'hélium He, l'air, le néon Ne, le krypton Kr, le xénon Xe, le monoxyde de carbone CO, le dioxyde de carbone CO₂.

Selon une caractéristique de l'invention, la couche interfaciale formée lors de l'étape d) présente une épaisseur comprise entre 1 pm et 5 nm.

Selon une caractéristique de l'invention, l'étape d) comporte les étapes :
d₁) former une couche interfaciale sur le substrat cristallin ;
d₂) nanostructurer la couche interfaciale en formant des nanotunnels traversants, agencés selon une répartition correspondant aux minima de l'énergie potentielle élastique identifiés lors de l'étape c).

Selon une caractéristique de l'invention, l'étape d₁) est exécutée par une technique choisie parmi :
- un collage, un collage avec activation de surface, un collage hybride, un collage par diffusion atomique ;
- un dépôt par laser pulsé ;
- un dépôt physique en phase vapeur, un dépôt chimique en phase vapeur, un dépôt chimique en phase vapeur assisté par plasma, un dépôt de couches atomiques, un dépôt de couches atomiques assisté par plasma, un dépôt assisté par faisceau d'ions, un dépôt assisté par faisceau d'électrons, un dépôt par faisceau d'ions ;
- une pulvérisation ;
- une évaporation ;
- une croissance additive ;
- une épitaxie, une épitaxie par jets moléculaires, une épitaxie en phase solide, une épitaxie induite par effet laser impulsionnel.

Selon une caractéristique de l'invention, l'étape d₂) est exécutée par une technique choisie parmi :
- une gravure à travers un masque, la gravure pouvant être une gravure sèche, une gravure humide ou une gravure plasma ; le masque étant de préférence auto-organisé ;
- une lithographie par faisceau d'ions, de préférence des ions hélium ;
- une lithographie par faisceau d'électrons ;
- une lithographie par faisceau de protons ;
- une lithographie par nano-impression, de préférence avec des motifs pyramidaux ;
- une lithographie par sonde à balayage, de préférence à balayage thermique ;
- une lithographie extrême ultraviolet.

Selon une caractéristique de l'invention, l'étape d₂) est suivie d'une étape d₂₀) appliquer un nettoyage de la couche interfaciale nanostructurée, adapté pour retirer des résidus de la nanostructuration exécutée lors de l'étape d₂).

Selon une caractéristique de l'invention, l'étape d₂₀) est exécutée par :
- un nettoyage chimique, en phase vapeur, en phase liquide, ou de type plasma ; ou par
- une gravure par faisceau d'ions.

Ainsi, un avantage procuré est de pouvoir retirer des résidus de la nanostructuration, ainsi que d'éventuellement modifier la sélectivité des dépôts du cristal dans les nanotunnels.

Selon une caractéristique de l'invention, l'étape d₂) est suivie d'une étape d₂₁) appliquer un traitement de surface de la couche interfaciale nanostructurée avec des ions hydrogène, de préférence implantés ou sous forme d'un plasma.

Ainsi, un avantage procuré est de désoxyder la surface, passiver les liaisons pendantes, et diminuer la défectivité de l'interface épitaxiale. Un tel traitement de surface peut également modifier la sélectivité des dépôts du cristal dans les nanotunnels car la passivation des liaisons pendantes bloque temporairement la formation de liaisons interatomiques.

Selon une caractéristique de l'invention, l'étape e) est exécutée par une technique choisie parmi :
- un collage, un collage direct, un collage direct assisté par laser, un collage avec activation de surface pouvant être sous vide, un collage hybride, un collage eutectique, un collage par thermocompression, un collage par diffusion atomique, un collage anodique, un collage humide pouvant être hydrophile ou hydrophobe, un collage avec activation plasma, un collage ultraviolet ;
- un dépôt par laser pulsé ;
- un dépôt physique en phase vapeur, un dépôt chimique en phase vapeur, un dépôt chimique en phase vapeur assisté par plasma, un dépôt de couches atomiques, un dépôt de couches atomiques assisté par plasma, un dépôt assisté par faisceau d'ions, un dépôt assisté par faisceau d'électrons, un dépôt par faisceau d'ions ;
- une pulvérisation ;
- une évaporation, de préférence sous vide ;
- une croissance additive ;
- un dépôt à la tournette ;
- une sérigraphie ;
- une épitaxie, une épitaxie à distance (« *remote epitaxy*» en langue anglaise), une épitaxie par jets moléculaires, une épitaxie en phase solide, une épitaxie induite par effet laser impulsionnel, une épitaxie en phase vapeur aux organométalliques.

Selon une caractéristique de l'invention, l'étape b) comporte une étape choisie parmi :
b₁) effectuer un calcul atomistique de l'interface modélisée lors de l'étape a) à l'aide d'un potentiel interatomique ; ou
b'₁) obtenir une figure de Moiré de l'interface modélisée lors de l'étape a) ; ou
b"₁) effectuer un calcul *ab initio* d'une structure de l'interface modélisée lors de l'étape a) ;
les étapes b₁), b'₁) et b"₁) étant mises en oeuvre au moyen d'un ordinateur.

Selon une caractéristique de l'invention, l'étape a) comporte une étape a₁) construire des mailles cristallines du cristal sur des mailles cristallines du substrat cristallin ; l'étape a₁) étant mise en oeuvre au moyen d'un ordinateur.

### Définitions

- Par « cristal/cristallin », on entend un solide dont les constituants sont assemblés de manière régulière. En d'autres termes, le diagramme de diffraction est essentiellement discret, conformément à la définition officiellement donnée par l'Union internationale de cristallographie (IUCR, *«International Union of Crystallography*»)*.* Le solide peut être monocristallin ou polycristallin, mais pas amorphe.
- Par « substrat », on entend un support physique autoporté. Un substrat peut être une tranche (également dénommée « plaquette », « *wafer*» en langue anglaise) qui se présente généralement sous la forme d'un disque issu d'une découpe dans un lingot d'un matériau cristallin.
- Par « réseau cristallin », on entend la répétition spatiale périodique de motifs (dénommés mailles cristallines) définissant la structure cristalline du cristal ou du substrat cristallin.
- Par « énergie potentielle élastique », on entend l'énergie élastique de déformation dans un solide cristallin, liée à l'interaction élastique entre les constituants (e.g. atomes) du solide cristallin. On parle également d'énergie potentielle d'interaction ou d'énergie élastique.
- Par « couche interfaciale », on entend une couche formant une interface entre le substrat cristallin et le cristal.
- Par « nanostructurée », on entend une couche comportant des motifs, généralement périodiques, de taille nanométrique ou subnanométrique.
- Par « nanotunnels traversants », on entend des orifices de taille nanométrique, traversant la couche interfaciale de part en part.
- Par « agencés selon une répartition correspondant aux minima de l'énergie potentielle élastique », on entend que chaque nanotunnel traversant est localisé dans une zone de la couche interfaciale centrée sur un minimum de l'énergie potentielle élastique. La zone de la couche interfaciale, centrée sur un minimum de l'énergie potentielle élastique, est circonscrite par une région de la couche interfaciale où l'énergie potentielle élastique est strictement inférieure à l'énergie minimale de formation des défauts étendus. En d'autres termes, la courbe d'iso-énergie de chaque nanotunnel traversant, définissant leur contour, est inscrite dans une région de la couche interfaciale où l'énergie potentielle élastique est strictement inférieure à l'énergie minimale de formation des défauts étendus.
- Par « sites de nucléation », on entend des zones du substrat cristallin propices à la formation d'une transition entre deux phases solides cristallines. On parle également de sites de germination.
- Par « matériau bidimensionnel », on entend un matériau constitué d'une seule couche de constituants (e.g. atomes, molécules). On parle également de matériau monocouche ou de matériau 2D.
- Par « épaisseur », on entend la dimension suivant la normale à la surface du substrat cristallin sur laquelle est formée la couche interfaciale.
- Par « calcul atomistique », on entend le calcul de l'énergie potentielle élastique à l'échelle atomique, par exemple à l'aide d'un potentiel interatomique (empirique) ou d'un calcul *ab initio.* Ce type de calcul permet de prédire la position de tous les atomes, notamment à l'interface, par minimisation globale de l'énergie totale du système.
- Par « figure de Moiré », on entend une figure résultant de la superposition des spots représentatifs des atomes du réseau cristallin du cristal et des spots représentatifs des atomes du réseau du substrat cristallin, et résultant d'un phénomène d'interférences spatiales entre les deux réseaux.
- Par « calcul *ab initio* », on entend un calcul de l'énergie potentielle élastique qui repose sur les lois physiques de base, telles que l'équation de Schrödinger.

### Brève description des dessins

D'autres caractéristiques et avantages apparaîtront dans l'exposé détaillé de différents modes de réalisation de l'invention, l'exposé étant assorti d'exemples et de références aux dessins joints.

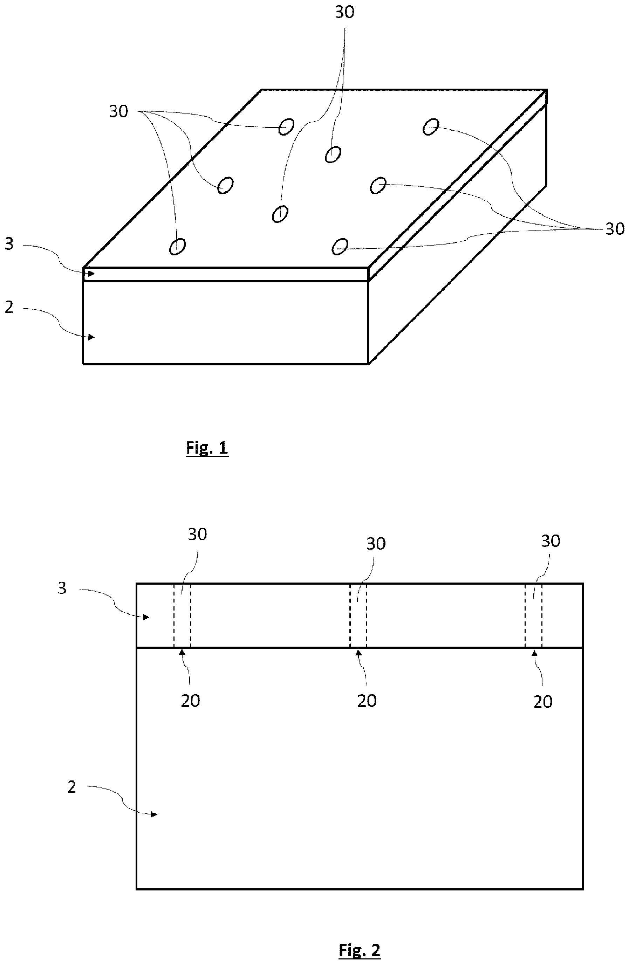

Figure 1 est une vue schématique en perspective, illustrant une étape d) d'un procédé selon l'invention.
Figure 2 est une vue schématique en coupe, illustrant une étape d) d'un procédé selon l'invention.

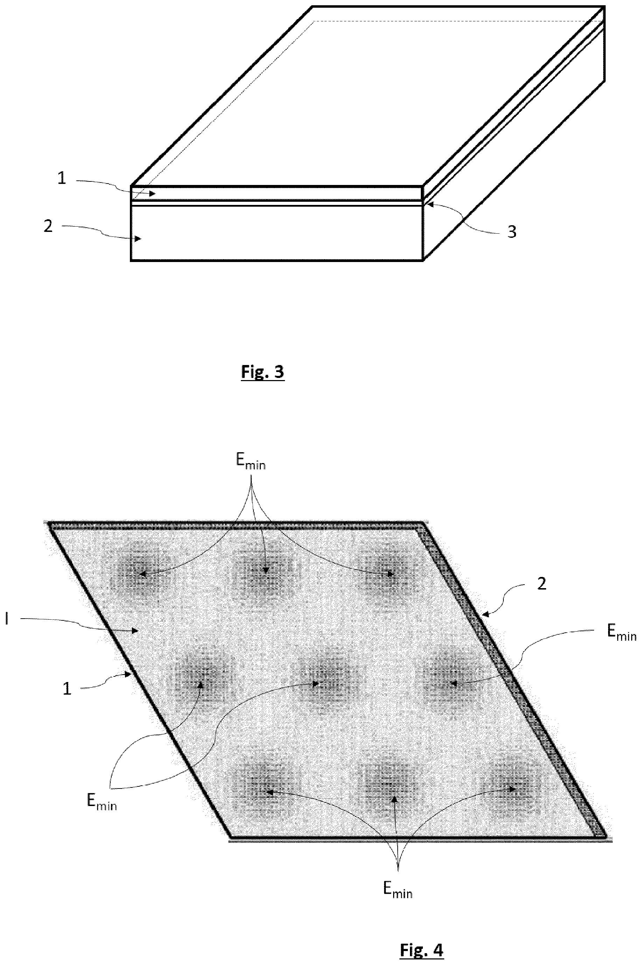

Figure 3 est une vue schématique en perspective, illustrant une étape d) d'un procédé selon l'invention.
Figure 4 est une vue schématique en perspective, illustrant une formation d'une couche interfaciale sur un substrat cristallin, les minima de l'énergie potentielle élastique de l'interface étant visibles en transparence.

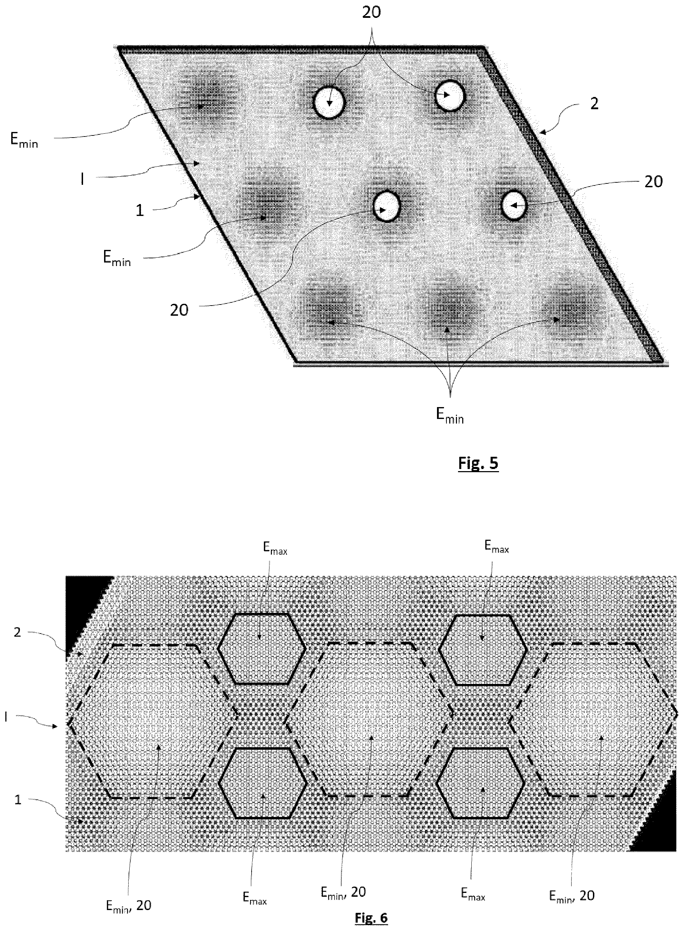

Figure 5 est une vue schématique en perspective, illustrant une nanostructuration de la couche interfaciale illustrée à la figure 4.
Figure 6 est une vue schématique de dessus, en transparence, illustrant une étape b'₁) d'un procédé selon l'invention.

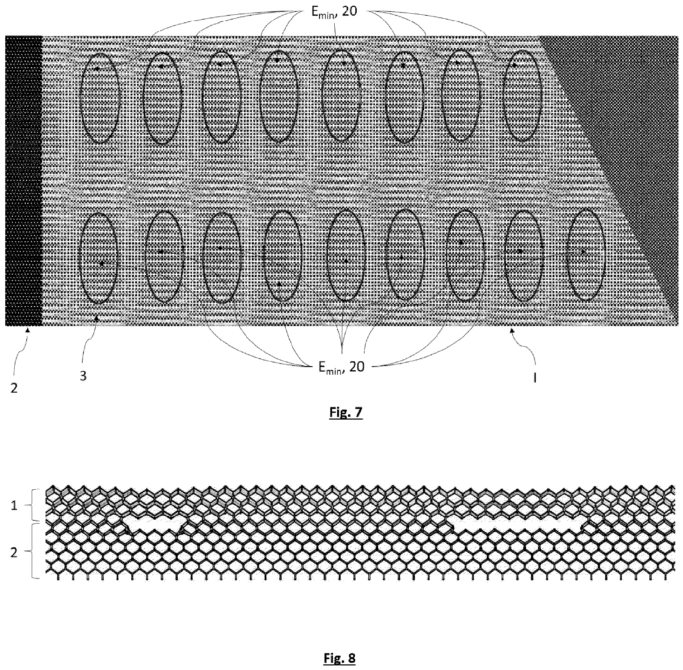

Figure 7 est une vue schématique de dessus, en transparence, illustrant une étape c) d'un procédé selon l'invention.
Figure 8 est une vue schématique en perspective, illustrant la formation de défauts au voisinage de nanotunnels traversants de trop petite taille.

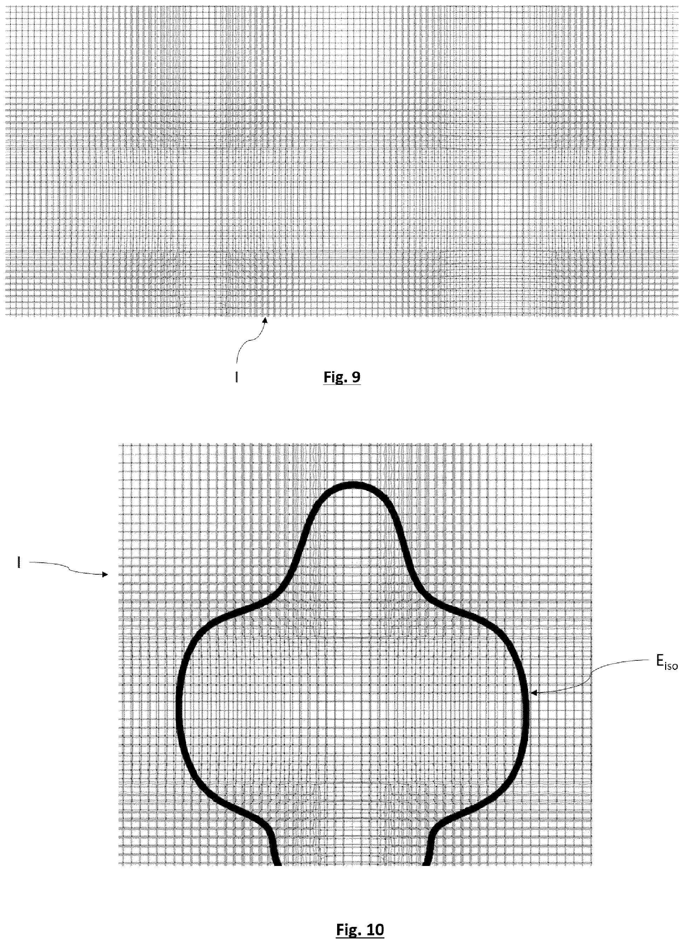

Figure 9 est une vue schématique de dessus, en transparence, illustrant une étape a) d'un procédé selon l'invention.
Figure 10 est une vue schématique de dessus, en transparence, illustrant une étape de détermination d'une ligne iso-énergie élastique correspondant à l'énergie de formation d'un défaut interfacial.

Il est à noter que les dessins décrits ci-avant sont schématiques, et ne sont pas nécessairement à l'échelle par souci de lisibilité et pour en simplifier leur compréhension. Les coupes sont effectuées selon la normale à la surface du substrat cristallin sur laquelle est formée la couche interfaciale.

### Exposé détaillé des modes de réalisation

Les éléments identiques ou assurant la même fonction porteront les mêmes références pour les différents modes de réalisation, par souci de simplification.

Un objet de l'invention est un procédé de fabrication d'un cristal 1 sur un substrat 2 cristallin, comportant les étapes :
a) modéliser une interface I entre un réseau cristallin du cristal 1 et un réseau cristallin du substrat 2 cristallin ;
b) déterminer une distribution spatiale d'une énergie potentielle élastique à l'interface I modélisée lors de l'étape a) ;
c) identifier des minima Eₘᵢₙ de l'énergie potentielle élastique à partir de la distribution spatiale déterminée lors de l'étape b) ;
d) former une couche interfaciale 3, nanostructurée, sur le substrat 2 cristallin ; la couche interfaciale 3 comportant des nanotunnels 30 traversants, agencés selon une répartition correspondant aux minima Eₘᵢₙ de l'énergie potentielle élastique identifiés lors de l'étape c) ; la couche interfaciale 3 étant formée d'une matière différente du cristal et du substrat cristallin ;
e) former le cristal 1 sur la couche interfaciale 3, via les nanotunnels 30 traversants délimitant des sites de nucléation 20 du substrat 2 cristallin.

### Etape a)

Une interface I entre un réseau cristallin du cristal 1 et un réseau cristallin du substrat 2 cristallin est modélisée lors de l'étape a). A titre d'exemple non limitatif, le cristal 1 peut être du nitrure d'aluminium AlN [001] et le substrat 2 cristallin peut être du nitrure de gallium GaN [001]. Bien entendu, toute interface I entre deux matériaux cristallins présentant un désaccord de maille peut être modélisée lors de l'étape a).

L'étape a) comporte avantageusement une étape a₁) construire des mailles cristallines du cristal 1 sur des mailles cristallines du substrat 2 cristallin. L'étape a₁) est avantageusement mise en oeuvre au moyen d'un ordinateur. A titre d'exemple non limitatif, l'étape a₁) peut être exécutée à l'aide du logiciel VESTA afin de visualiser les positions des atomes à partir de fichiers des positions. Dans le cas de cristaux nouveaux et non publiés, un calcul *ab initio* permet de prédire les positions atomiques et de générer le fichier des positions.

### Etape b)

Une distribution spatiale d'une énergie potentielle élastique à l'interface I modélisée lors de l'étape a) est déterminée lors de l'étape b).

L'étape b) comporte avantageusement une étape choisie parmi :
b₁) effectuer un calcul atomistique de l'interface I modélisée lors de l'étape a) à l'aide d'un potentiel interatomique ; ou
b'₁) obtenir une figure de Moiré de l'interface I modélisée lors de l'étape a) ; ou
b"₁) effectuer un calcul *ab initio* d'une structure de l'interface I modélisée lors de l'étape a).

Les étapes b₁), b'₁) et b"₁) sont avantageusement mises en oeuvre au moyen d'un ordinateur.

A titre d'exemple non limitatif, le potentiel interatomique (empirique) utilisé lors de l'étape b₁) peut être calculé par un potentiel de type Keating connu de l'homme du métier, ou par exemple à l'aide d'un potentiel interatomique obtenu par une technique d'intelligence artificielle. D'autres potentiels interatomiques peuvent être utilisés, par exemple le potentiel par la méthode de l'atome enrobé EAM (« *Embedded Atom Method* » en langue anglaise), le potentiel par la méthode de l'atome enrobé modifiée MEAM (« *Modified Embedded Atom Method*» en langue anglaise), le potentiel angulaire dépendant ADP («*Angular Dependent Potential*» en langue anglaise) etc. L'étape b₁) peut être exécutée par une méthode de type dynamique moléculaire, ou similaire.

A titre d'exemple non limitatif, la figure de Moiré peut être obtenue lors de l'étape b'₁) par superposition numérique des spots représentatifs des atomes au moyen d'un logiciel de représentation des positions atomiques (e.g. VESTA). La variation exploratoire de la taille des spots atomiques dans le logiciel permet d'ajuster le contraste du Moiré.

A titre d'exemple non limitatif, le calcul *ab initia* de la structure peut être effectué par une approche dite de champ moyen, ou par une approche dite perturbative, ces approches étant connues de l'homme du métier.

### Etape c)

Des minima Eₘᵢₙ de l'énergie potentielle élastique sont identifiés lors de l'étape c), à partir de la distribution spatiale déterminée lors de l'étape b).

La distribution spatiale déterminée lors de l'étape b) peut également mettre en évidence des maxima Eₘₐₓ de l'énergie potentielle élastique, réservoirs potentiels de défauts, qui seront masqués par la couche interfaciale 3 recouvrant ces zones.

### Etape d)

Une couche interfaciale 3, nanostructurée, est formée sur le substrat 2 cristallin lors de l'étape c).

La couche interfaciale 3 comporte des nanotunnels 30 traversants, agencés selon une répartition correspondant aux minima Eₘᵢₙ de l'énergie potentielle élastique identifiés lors de l'étape c). Plus précisément, les nanotunnels 30 traversants sont agencés selon une répartition correspondant à tout ou partie des minima Eₘᵢₙ de l'énergie potentielle élastique identifiés lors de l'étape c). Chaque nanotunnel 30 traversant est localisé dans une zone de la couche interfaciale 3 centrée sur un minimum Eₘᵢₙ de l'énergie potentielle élastique. La zone de la couche interfaciale 3, centrée sur un minimum Eₘᵢₙ de l'énergie potentielle élastique, est circonscrite par une région de la couche interfaciale 3 où l'énergie potentielle élastique est strictement inférieure à l'énergie minimale de formation des défauts étendus. En d'autres termes, la courbe d'iso-énergie de chaque nanotunnel 30 traversant, définissant leur contour, est inscrite dans une région de la couche interfaciale 3 où l'énergie potentielle élastique est strictement inférieure à l'énergie minimale de formation des défauts étendus.

La dimension des nanotunnels 30 traversants est avantageusement calculée de manière atomistique par comparaison entre l'énergie potentielle élastique locale et l'énergie de formation des défauts étendus qui seraient susceptibles de se former en l'absence de nanotunnels 30 traversants. Si l'énergie potentielle élastique locale est supérieure au seuil critique d'énergie de formation des défauts étendus, alors ce type de défauts risque d'être formé. Ainsi, toute zone comportant une énergie potentielle élastique localement supérieure au seuil de formation des défauts étendus est masquée par les nanotunnels 30 traversants pour éviter la germination de ce type de défauts. La taille optimale des nanotunnels 30 traversants est obtenu par itérations, par exemple par remplacement d'atomes suivi d'une minimisation de l'énergie du système, de manière à obtenir une énergie potentielle élastique interfaciale toujours en-dessous du seuil critique de formation des défauts étendus. Plus précisément, un calcul atomistique permet d'obtenir des courbes d'iso-énergie Eᵢₛₒ, pour une énergie de formation donnée d'un défaut (notée E_{f}), définissant la limite du contour à respecter pour la nanostructuration, c'est-à-dire le contour critique à ne pas dépasser pour les nanotunnels 30 traversants. En d'autres termes, les nanotunnels 30 traversants doivent s'étendre sur une superficie inférieure ou égale à la superficie du contour délimité par la courbe d'iso-énergie Eᵢₛₒ. La géométrie des nanotunnels 30 traversants dépend des phases cristallines et des orientations cristallines à l'interface I modélisée lors de l'étape a). En particulier, lorsque les dimensions des nanotunnels 30 traversants sont trop importantes (i.e. superficie supérieure à la superficie du contour délimité par la courbe d'iso-énergie Eᵢₛₒ), des défauts se forment dans les régions les plus contraintes correspondant à l'énergie potentielle élastique localement la plus élevée. Il faut donc choisir la courbe d'iso-énergie Eᵢₛₒ, définissant le contour des nanotunnels 30 traversants, permettant de vérifier la relation Eᵢₛₒ < E_{f}.

La couche interfaciale 3 est formée d'une matière à la fois différente de la matière du cristal et de la matière du substrat cristallin. La matière de la couche interfaciale 3 formée lors de l'étape d) peut être en phase solide ou en phase gazeuse.

La matière en phase solide de la couche interfaciale 3 formée lors de l'étape d) est avantageusement choisie parmi :
- un dichalcogénure d'un métal de transition, de préférence le disulfure de molybdène MoS₂, le disulfure d'étain SnS₂, le disulfure de tungstène WS₂, le disulfure de vanadium VS₂, le disulfure de titane TiS₂ ;
- le graphène ou un dérivé du graphène, le dérivé du graphène étant de préférence un carbone amorphe notamment hydrogéné, un carbone de type diamant, une structure haeckelite ;
- un nitrure de bore BN, notamment hydrogéné, de préférence hexagonal ;
- un matériau de formule brute SiOₓC_{y}H_{z} ;
- un copolymère à blocs, de préférence auto-organisé ;
- un carbure d'un métal de transition, de préférence de type MXene ;
- un réseau métallo-organique,
- le borophène, le silicène, le germanène, le stanène, le phosphorène.

La matière en phase gazeuse de la couche interfaciale 3 formée lors de l'étape d) est avantageusement choisie parmi le dihydrogène H₂, le diazote N₂, le dioxygène O₂, l'argon Ar, l'hélium He, l'air, le néon Ne, le krypton Kr, le xénon Xe, le monoxyde de carbone CO, le dioxyde de carbone CO₂. Dans ce mode de réalisation, les nanotunnels 30 traversants sont remplis de la matière en phase gazeuse et sont formés concomitamment à la couche interfaciale 3. La matière en phase gazeuse de la couche interfaciale 3 formée lors de l'étape d) peut être des gaz précurseurs, plus précisément des résidus de gaz de croissance qui n'ont pas réagi. Autrement dit, les nanotunnels 30 traversants peuvent être formés dans une couche interfaciale 3 gazeuse adsorbée à la surface d'un solide (i.e. sur le substrat 2 cristallin). Par exemple, lorsque la matière en phase gazeuse de la couche interfaciale 3 est le dihydrogène H₂, il est possible de former des liaisons hydrogène avec la surface du substrat 2 cristallin. Lorsque le substrat 2 cristallin est réalisé en silicium, des monohydrures de silicium (-Si-H) et des dihydrures de silicium (-Si-H₂) peuvent être formés. L'avantage des liaisons hydrogène est de bloquer les liaisons pendantes, la surface du substrat 2 cristallin n'étant donc plus réactive et par là-même efficace pour bloquer la croissance. Pour enlever une partie de la phase gazeuse (et donc former les nanotunnels 30 traversants), plusieurs techniques sont envisageables :
(i) chauffer localement, par exemple avec une pointe chauffée d'un microscope à force atomique ;
(ii) frotter localement, par exemple avec une pointe d'un microscope à effet tunnel ;
(iii) envoyer localement des ions hélium avec une sonde ionique focalisée.

La couche interfaciale 3 formée lors de l'étape d) présente avantageusement une épaisseur comprise entre 1 pm et 5 nm. La couche interfaciale 3 formée lors de l'étape d) est avantageusement une monocouche formant un matériau bidimensionnel. Toutefois, il est possible d'empiler plusieurs monocouches (formant chacune un matériau bidimensionnel) pour ajuster l'épaisseur de la couche interfaciale 3 formée lors de l'étape d). C'est la simulation atomistique qui donne l'épaisseur optimale de la couche interfaciale 3.

L'étape d) comporte avantageusement les étapes :
d₁) former une couche interfaciale 3 sur le substrat 2 cristallin ;
d₂) nanostructurer la couche interfaciale 3 en formant des nanotunnels 30 traversants, agencés selon une répartition correspondant aux minima Eₘᵢₙ de l'énergie potentielle élastique identifiés lors de l'étape c).

L'étape d₁) est avantageusement exécutée par une technique choisie parmi :
- un collage, un collage avec activation de surface, un collage hybride, un collage par diffusion atomique ;
- un dépôt par laser pulsé ;
- un dépôt physique en phase vapeur, un dépôt chimique en phase vapeur, un dépôt chimique en phase vapeur assisté par plasma, un dépôt de couches atomiques, un dépôt de couches atomiques assisté par plasma, un dépôt assisté par faisceau d'ions, un dépôt assisté par faisceau d'électrons, un dépôt par faisceau d'ions ;
- une pulvérisation ;
- une évaporation ;
- une croissance additive ;
- une épitaxie, une épitaxie par jets moléculaires, une épitaxie en phase solide, une épitaxie induite par effet laser impulsionnel.

L'étape d₂) est avantageusement exécutée par une technique choisie parmi :
- une gravure à travers un masque, la gravure pouvant être une gravure sèche, une gravure humide ou une gravure plasma ; le masque étant de préférence auto-organisé ;
- une lithographie par faisceau d'ions, de préférence des ions hélium ;
- une lithographie par faisceau d'électrons ;
- une lithographie par faisceau de protons ;
- une lithographie par nano-impression, de préférence avec des motifs pyramidaux ;
- une lithographie par sonde à balayage, de préférence à balayage thermique ;
- une lithographie extrême ultraviolet.

L'étape d₂) est avantageusement suivie d'une étape d₂₀) appliquer un nettoyage de la couche interfaciale 3 nanostructurée, le nettoyage étant adapté pour retirer des résidus de la nanostructuration exécutée lors de l'étape d₂). L'étape d₂₀) est avantageusement exécutée par :
- un nettoyage chimique, en phase vapeur, en phase liquide, ou de type plasma ; ou par
- une gravure par faisceau d'ions.

L'étape d₂) est avantageusement suivie d'une étape d₂₁) appliquer un traitement de surface de la couche interfaciale 3 nanostructurée avec des ions hydrogène. Les ions hydrogène sont de préférence implantés ou sous forme d'un plasma.

A titre d'exemple de mise en oeuvre simple de l'étape d), il est possible de nanostructurer préalablement une couche interfaciale 3 (e.g. un matériau bidimensionnel) sur un support temporaire. Des nanotunnels 30 traversants peuvent être formés au sein du matériau bidimensionnel, par exemple avec un faisceau d'hélium, un faisceau d'électons, ou avec une pointe chauffée. L'ensemble comportant le support temporaire et le matériau bidimensionnel nanostructuré est ensuite retourné et collé sur le substrat 2 cristallin. Puis le support temporaire est retiré, de même que les éventuels résidus. Un avantage de cet exemple de mise en oeuvre est que le substrat 2 cristallin n'est pas impacté par l'étape de formation des nanotunnels 30 traversants.

### Etape e)

Le cristal 1 est formé sur la couche interfaciale 3 lors de l'étape e), via les nanotunnels 30 traversants délimitant des sites de nucléation 20 du substrat 2 cristallin.

L'étape e) est avantageusement exécutée par une technique choisie parmi :
- un collage, un collage direct, un collage direct assisté par laser, un collage avec activation de surface pouvant être sous vide, un collage hybride, un collage eutectique, un collage par thermocompression, un collage par diffusion atomique, un collage anodique, un collage humide pouvant être hydrophile ou hydrophobe, un collage avec activation plasma, un collage ultraviolet ;
- un dépôt par laser pulsé ;
- un dépôt physique en phase vapeur, un dépôt chimique en phase vapeur, un dépôt chimique en phase vapeur assisté par plasma, un dépôt de couches atomiques, un dépôt de couches atomiques assisté par plasma, un dépôt assisté par faisceau d'ions, un dépôt assisté par faisceau d'électrons, un dépôt par faisceau d'ions ;
- une pulvérisation ;
- une évaporation, de préférence sous vide ;
- une croissance additive ;
- un dépôt à la tournette ;
- une sérigraphie ;
- une épitaxie, une épitaxie à distance, une épitaxie par jets moléculaires, une épitaxie en phase solide, une épitaxie induite par effet laser impulsionnel, une épitaxie en phase vapeur aux organométalliques.

L'étape e) peut être suivie d'une étape e₁) appliquer un recuit thermique, de préférence sous atmosphère chimiquement contrôlée, adapté pour vaporiser la couche interfaciale 3. Selon une alternative, le recuit thermique peut être adapté pour recristalliser des couches.

A titre d'exemple de mise en oeuvre simple de l'étape e), après le retrait du support temporaire et des éventuels résidus, le cristal 1 est déposé et un recuit thermique est appliqué pour obtenir une épitaxie à l'intérieur des nanotunnels 30 traversants. L'extension des zones cristallines autour des nanotunnels 30 traversants est calculée pour aboutir à un monocristal par extension et fusion des grains de croissance épitaxiale initiés dans les nanotunnels 30 traversants.

L'invention ne se limite pas aux modes de réalisation exposés. L'homme du métier est mis à même de considérer leurs combinaisons techniquement opérantes, et de leur substituer des équivalents.

## Revendications

1. Procédé de fabrication d'un cristal (1) sur un substrat (2) cristallin, comportant les étapes :
a) modéliser une interface (I) entre un réseau cristallin du cristal (1) et un réseau cristallin du substrat (2) cristallin ;
b) déterminer une distribution spatiale d'une énergie potentielle élastique à l'interface (I) modélisée lors de l'étape a) ;
c) identifier des minima (Eₘᵢₙ) de l'énergie potentielle élastique à partir de la distribution spatiale déterminée lors de l'étape b) ;
d) former une couche interfaciale (3), nanostructurée, sur le substrat (2) cristallin ; la couche interfaciale comportant des nanotunnels (30) traversants, agencés selon une répartition correspondant aux minima (Eₘᵢₙ) de l'énergie potentielle élastique identifiés lors de l'étape c) ; la couche interfaciale (3) étant formée d'une matière différente du cristal (1) et du substrat (2) cristallin ;
e) former le cristal (1) sur la couche interfaciale (30), via les nanotunnels (30) traversants délimitant des sites de nucléation (20) du substrat (2) cristallin.

2. Procédé selon la revendication 1, dans lequel la couche interfaciale (3) formée lors de l'étape d) est une monocouche formant un matériau bidimensionnel.

3. Procédé selon la revendication 1 ou 2, dans lequel la matière de la couche interfaciale (3) formée lors de l'étape d) est en phase solide ou en phase gazeuse.

4. Procédé selon la revendication 3, dans lequel la matière en phase solide de la couche interfaciale (3) formée lors de l'étape d) est choisie parmi :
- un dichalcogénure d'un métal de transition, de préférence le disulfure de molybdène MoS₂, le disulfure d'étain SnS₂, le disulfure de tungstène WS₂, le disulfure de vanadium VS₂, le disulfure de titane TiS₂ ;
- le graphène ou un dérivé du graphène, le dérivé du graphène étant de préférence un carbone amorphe notamment hydrogéné, un carbone de type diamant, une structure haeckelite ;
- un nitrure de bore BN, notamment hydrogéné, de préférence hexagonal ;
- un matériau de formule brute SiOₓC_{y}H_{z} ;
- un copolymère à blocs, de préférence auto-organisé ;
- un carbure d'un métal de transition, de préférence de type MXene ;
- un réseau métallo-organique,
- le borophène, le silicène, le germanène, le stanène, le phosphorène.

5. Procédé selon la revendication 3, dans lequel la matière en phase gazeuse de la couche interfaciale (3) formée lors de l'étape d) est choisie parmi le dihydrogène H₂, le diazote N₂, le dioxygène O₂, l'argon Ar, l'hélium He, l'air, le néon Ne, le krypton Kr, le xénon Xe, le monoxyde de carbone CO, le dioxyde de carbone CO₂.

6. Procédé selon l'une des revendications 1 à 5, dans lequel la couche interfaciale (3) formée lors de l'étape d) présente une épaisseur comprise entre 1 pm et 5 nm.

7. Procédé selon l'une des revendications 1 à 6, dans lequel l'étape d) comporte les étapes :
d₁) former une couche interfaciale (3) sur le substrat (2) cristallin ;
d₂) nanostructurer la couche interfaciale (3) en formant des nanotunnels (30) traversants, agencés selon une répartition correspondant aux minima (Eₘᵢₙ) de l'énergie potentielle élastique identifiés lors de l'étape c).

8. Procédé selon la revendication 7, dans lequel l'étape d₁) est exécutée par une technique choisie parmi :
- un collage, un collage avec activation de surface, un collage hybride, un collage par diffusion atomique ;
- un dépôt par laser pulsé ;
- un dépôt physique en phase vapeur, un dépôt chimique en phase vapeur, un dépôt chimique en phase vapeur assisté par plasma, un dépôt de couches atomiques, un dépôt de couches atomiques assisté par plasma, un dépôt assisté par faisceau d'ions, un dépôt assisté par faisceau d'électrons, un dépôt par faisceau d'ions ;
- une pulvérisation ;
- une évaporation ;
- une croissance additive ;
- une épitaxie, une épitaxie par jets moléculaires, une épitaxie en phase solide, une épitaxie induite par effet laser impulsionnel.

9. Procédé selon la revendication 7 ou 8, dans lequel l'étape d₂) est exécutée par une technique choisie parmi :
- une gravure à travers un masque, la gravure pouvant être une gravure sèche, une gravure humide ou une gravure plasma ; le masque étant de préférence auto-organisé ;
- une lithographie par faisceau d'ions, de préférence des ions hélium ;
- une lithographie par faisceau d'électrons ;
- une lithographie par faisceau de protons ;
- une lithographie par nano-impression, de préférence avec des motifs pyramidaux ;
- une lithographie par sonde à balayage, de préférence à balayage thermique ;
- une lithographie extrême ultraviolet.

10. Procédé selon l'une des revendications 7 à 9, dans lequel l'étape d₂) est suivie d'une étape d₂₀) appliquer un nettoyage de la couche interfaciale (3) nanostructurée, adapté pour retirer des résidus de la nanostructuration exécutée lors de l'étape d₂).

11. Procédé selon la revendication 10, dans lequel l'étape d₂₀) est exécutée par :
- un nettoyage chimique, en phase vapeur, en phase liquide, ou de type plasma ; ou par
- une gravure par faisceau d'ions.

12. Procédé selon l'une des revendications 7 à 11, dans lequel l'étape d₂) est suivie d'une étape d₂₁) appliquer un traitement de surface de la couche interfaciale (3) nanostructurée avec des ions hydrogène, de préférence implantés ou sous forme d'un plasma.

13. Procédé selon l'une des revendications 1 à 12, dans lequel l'étape e) est exécutée par une technique choisie parmi :
- un collage, un collage direct, un collage direct assisté par laser, un collage avec activation de surface pouvant être sous vide, un collage hybride, un collage eutectique, un collage par thermocompression, un collage par diffusion atomique, un collage anodique, un collage humide pouvant être hydrophile ou hydrophobe, un collage avec activation plasma, un collage ultraviolet ;
- un dépôt par laser pulsé ;
- un dépôt physique en phase vapeur, un dépôt chimique en phase vapeur, un dépôt chimique en phase vapeur assisté par plasma, un dépôt de couches atomiques, un dépôt de couches atomiques assisté par plasma, un dépôt assisté par faisceau d'ions, un dépôt assisté par faisceau d'électrons, un dépôt par faisceau d'ions ;
- une pulvérisation ;
- une évaporation, de préférence sous vide ;
- une croissance additive ;
- un dépôt à la tournette ;
- une sérigraphie ;
- une épitaxie, une épitaxie à distance, une épitaxie par jets moléculaires, une épitaxie en phase solide, une épitaxie induite par effet laser impulsionnel, une épitaxie en phase vapeur aux organométalliques.

14. Procédé selon l'une des revendications 1 à 13, dans lequel l'étape b) comporte une étape choisie parmi :
b₁) effectuer un calcul atomistique de l'interface (I) modélisée lors de l'étape a) à l'aide d'un potentiel interatomique ; ou
b'₁) obtenir une figure de Moiré de l'interface (I) modélisée lors de l'étape a) ; ou
b"₁) effectuer un calcul *ab initio* d'une structure de l'interface (I) modélisée lors de l'étape a) ;
les étapes b₁), b'₁) et b"₁) étant mises en oeuvre au moyen d'un ordinateur.

15. Procédé selon l'une des revendications 1 à 14, dans lequel l'étape a) comporte une étape a₁) construire des mailles cristallines du cristal (1) sur des mailles cristallines du substrat (2) cristallin ; l'étape a₁) étant mise en oeuvre au moyen d'un ordinateur.
